Europäisches Patentamt

European Patent Office

Office européen des brevets

(11) Veröffentlichungsnummer: **0 141 191**
A2

## (12) EUROPÄISCHE PATENTANMELDUNG

(21) Anmeldenummer: 84110882.2

(22) Anmeldetag: 12.09.84

(51) Int. Cl.⁴: **H 04 B 9/00**
H 01 S 3/103

(30) Priorität: 14.09.83 DE 3333248

(43) Veröffentlichungstag der Anmeldung:
15.05.85 Patentblatt 85/20

(84) Benannte Vertragsstaaten:
AT BE CH DE FR GB IT LI NL SE

(71) Anmelder: Siemens Aktiengesellschaft
Berlin und München Wittelsbacherplatz 2
D-8000 München 2(DE)

(72) Erfinder: Barabas, Udo, Professor, Dr.-Ing.
Gärtnerstrasse 36 b
D-8298 Kolbermoor(DE)

(72) Erfinder: Teuschl, Franz, Dipl.-Ing.
Pollinger Strasse 22
D-8000 München 70(DE)

(54) Laserregelung für optische Übertragungssysteme.

(57) Bei optischen Übertragungssystemen ist es bekannt, sowohl den Vorstrom als auch den Modulationsstrom der als Sender verwendeten Laserdiode zu regeln.

In der Einschaltphase kann bei abgeschalteter oder sich nur langsam einstellender Vorstromregelung eine Überlastung der Laserdioden auftreten, da zunächst die Signalspitzen des Modulationsstroms die Laserdiode aussteuern. Erfindungsgemäß wird deshalb in der Einschaltphase zunächst der Modulationsstrom und damit auch der von der Laserdiode abgebbare Spitzenwert des Lichtes auf einen ungefährlichen Wert begrenzt.

Diese Begrenzung wird nach Überschreiten des Schwellenwertes der Laserdiode bei Gleichheit des von der Laserdiode abgegebenen Lichtmittelwertes mit dem vorgegebenem reduzierten Lichtmittelwert abgeschaltet.

Das erfindungsgemäße Verfahren und eine entsprechende Anordnung sind insbesondere für die Übertragung digitaler Signale mit Bitraten von über 100 Mbit/s geeignet.

FIG 1

SIEMENS AKTIENGESELLSCHAFT
Berlin und München

VPA
83 P 1677 E

## Laserregelung für optische Übertragungssysteme

Die Erfindung betrifft ein Verfahren zur Regelung des Vorstroms und des Modulationsstroms von Laserdioden durch Auswertung des Mittelwertes des erzeugten Lichtes und eines zusätzlich übertragenen, gegenüber den Übertragungssignalen vergleichsweise niederfrequenten Pilotsignals geringer Amplitude, bei dem ein Teil des von der Laserdiode abgestrahlten Lichtes am Ort in eine elektrische Spannung umgeformt wird und aus der Höhe dieser Spannung die mittlere Lichtleistung der Laserdiode ermittelt wird, daß die mittlere Lichtleistung der Laserdiode zur Steuerung des Modulationsstroms und die Pilotsignalamplitude im abgestrahlten Licht bzw. der daraus erzeugten Spannung zur Steuerung des Vorstroms verwendet wird und während der Einschaltphase die Modulationsstromregelung abgeschaltet ist und eine Anordnung zur Durchführung des Verfahrens.

In optischen Übertragungssystemen wird als Lichtsender häufig eine Laserdiode verwendet. Die Licht-Stromkennlinie derartiger Laserdioden weist einen charakteristischen Knick auf, die kohärente Lichtausstrahlung beginnt also erst bei einem bestimmten Schwellenwert des Stroms. Neben dem Modulationsstrom, der die zu übertragende Nachricht enthält, wird deshalb die Laserdiode mit einem Vorstrom beaufschlagt, der als Gleichstrom zur Arbeitspunkteinstellung dient. Wegen der Streuung der Kennlinienparameter von Laserdioden und der Veränderung dieser Parameter in Abhängigkeit beispielsweise von der Laserdiodentemperatur ist eine automatische Einstellung und Regelung von Vorstrom und Modulationsstrom der Laserdiode erforderlich und inzwischen auch bekannt. Wegen der großen Gefährdung der Laserdiode auch durch kurzzeitige Überlast gewinnt

9.9.83 / Ah 1 Seu

das Einschaltverhalten von Laserdiodensendern erhöhte Bedeutung.

In der Einschaltphase kann in der Zeit, in der der Arbeitspunkt der Laserdiode durch den Vorstrom noch nicht eingestellt ist, der Sollwert der mittleren Lichtleistung durch einen hinreichend weit aufgeregelten Signalstrom jedoch praktisch erreicht ist, eine zu hohe Lichtspitzenleistung an der Laserdiode auftreten. Die Ursache dafür liegt darin, daß zunächst bei zu kleinem Vorstrom der Laser zunächst durch die Signalspitzen des Modulationsstroms ausgesteuert wird. Besonders in hochratigen Übertragungssystemen mit nicht vernachlässigbaren Anstiegs- und Abfallzeiten ergeben sich dann zeitlich gesehen relativ schmale Lichtimpulsspitzen, durch die aufgrund des Bestrebens der Mittelwertregelung, den gewählten Lichtmittelwert einzustellen bzw. zu erhalten eine zu hohe Lichtspitzenleistung an der Laserdiode auftreten kann.

Die Aufgabe der Erfindung liegt also darin, eine Gefährdung der Laserdiode durch eine zu hohe Lichtspitzenleistung in der Einschaltphase zu vermeiden.

Erfindungsgemäß wird die Aufgabe durch ein Verfahren der eingangs erwähnten Art dadurch gelöst, daß in der Einschaltphase zunächst der Modulationsstrom und damit auch der von der Laserdiode abgebbare Lichtspitzenwert auf einen für derartige Laserdioden ungefährlichen Wert begrenzt sind, daß nach Überschreiten des Schwellenwertes der Laserdiode durch die Summe aus Vorstrom und wirksamen Modulationsstrom bei Gleichheit des von der Laserdiode abgegebenen Lichtmittelwertes mit dem vorgegebenen reduzierten Lichtmittelwert die Modulationsstrombegrenzung abgeschaltet wird.

Die erfindungsgemäße Lösung bietet den Vorteil, sowohl für digitale als auch für analoge optische Übertragungssysteme mit impulsförmigem Träger auch bei hoher Übertragungsgeschwindigkeit verwendbar zu sein, so daß beispielsweise bei einem digitalen optischen Übertragungssystem auch Bitraten von weit über 100 Mbit/s übertragen werden können. In den Patentansprüchen 2 bis 6
wird neben Weiterbildungen des erfindungsgemäßen Verfahrens auch eine erfindungsgemäße Anordnung zur Durchführung des Verfahrens beschrieben.

Die Erfindung soll im folgenden anhand der Zeichnung
näher erläutert werden.
In der Zeichnung zeigt.
Fig. 1 eine schematisierte Anordnung zur Laserregelung
nach der Erfindung und
Fig. 2 eine Darstellung des zeitlichen Verlaufs der
Steuervorgänge in der Anordnung nach Fig. 1.

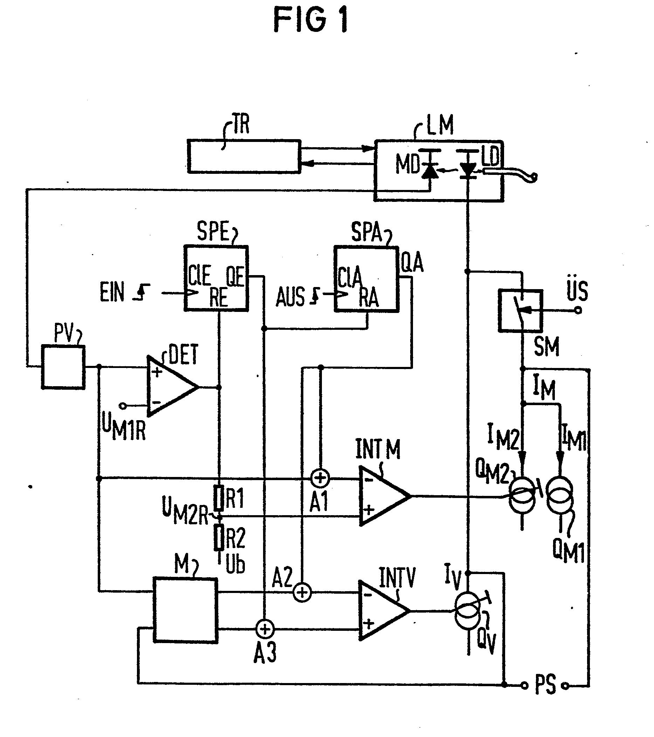

In der Fig. 1 ist mit LM der Lasermodul bezeichnet, der
die Laserdiode LD mit angedeutetem Lichtwellenleiter
sowie eine optisch angekoppelte Monitordiode MD enthält. Mit dem Lasermodul LM thermisch verbunden ist eine
Temperaturregelung TR, die in. bekannter Weise einen Peltierkühler enthält.

Der Fotostrom der Monitordiode MD wird in einem Verstärker PV in bekannter Weise verstärkt und in eine
Spannung umgewandelt. Diese Spannung wird an den positiven
Eingang eines als Schwellenwertdetektor DET wirksamen
Differenzverstärker abgegeben, an dessen negativem Eingang
eine Referenzspannung $U_{M1R}$ anliegt. Die Ausgangsspannung
des Verstärkers PV wird weiterhin über eine erste lineare
Addierschaltung A1 an den einen Eingang eines Modulationsstrom-Integrators INTM abgegeben, der in Form eines
Differenzverstärkers mit Speicherverhalten aufgebaut ist.
Mit dem Ausgang des Verstärkers PV ist außerdem ein Eingang eines Mischers M verbunden, der Mischer enthält ein

**0141191**

mit dem Eingang verbundenes Filter, das aus dem Ausgangssignal des Verstärkers PV die sendeseitig zugesetzte Pilotsignalkomponente aussiebt. Der andere Eingang des Mischers M ist mit einem Anschluß der Pilotsignalquelle PS verbunden. Die beiden Ausgänge des Mischers M, der einen Vergleich zwischen den beiden an seinen Eingängen anstehenden Pilotsignalen durchführt, sind über eine zweite bzw. eine dritte lineare Addierschaltung A2, A3 getrennt mit den Eingängen eines Integrators INTV für den Vorstrom verbunden. Mit dem Ausgang dieses Integrators ist ein Stellglied verbunden, das entsprechend der Ausgangsspannung des Integrators INTV den Ausgangsstrom $I_V$ einer Quelle $Q_V$ für den Vorstrom regelt. Der Ausgang dieser Quelle ist direkt mit der Laserdiode LD und außerdem mit demjenigen Anschluß der Pilotsignalquelle PS verbunden, an den auch der eine Eingang des Mischers M geführt ist.

Der Modulationsstrom $I_M$ wird aus zwei Teilströmen $I_{M1}$, $I_{M2}$ erzeugt. Der erste Teilstrom $I_{M1}$ entstammt einer Quelle $Q_{M1}$ und ist so bemessen, daß er dem in der Einschaltphase maximal zulässigen Modulationsstrom entspricht. Der Ausgang des Integrators INTV ist mit einem Stellglied verbunden, das den Ausgangsstrom einer zweiten Quelle $Q_{M2}$ für den zweiten Modulations-Teilstrom $I_{M2}$ regelt. Der aus den beiden Teilströmen gebildete Modulationsstrom $I_M$ wird über einen gesteuerten Schalter SM an die Laserdiode LD geführt, deren anderer Anschluß mit Bezugspotential verbunden ist. Der Schalter SM wird vom Übertragungssignal ÜS gesteuert, so daß die zu übertragende Information in der Tastung des Modulationsstroms enthalten ist. Zur Überlagerung des Pilotsignals während der Signalimpulse sind die Ausgänge der beiden Modulationsstromquellen mit demjenigen Anschluß der Pilotsignalquelle PS verbunden, dessen Ausgangssignal gegenphasig zum Pilotsignal am Mischereingang ist.

Zusätzlich enthält der Lasersender nach der Fig. 1 noch
ein erstes und ein zweites D-Flipflop SPE, SPA, die beide
bei ansteigender Impulsflanke am Takteingang umschalten.
Das erste D-Flipflop SPE dient als Speicher für den Einschaltzustand, mit dessen Takteingang CLE ist ein Tastschalter oder ähnliches, bzw. eine Einschaltelektronik,
zu verbinden, über den der Laserdiodensender eingeschaltet werden kann. Der Rücksetzeingang RE des ersten D-
Flipflop ist mit dem Ausgang des Schwellenwertdetektors DET
und außerdem über einen ersten Widerstand R1 mit dem
zweiten Eingang des Integrators INTM und von da über
einen zweiten Widerstand R2 mit Betriebsspannung Ub verbunden. Der Ausgang QE des ersten D-Flipflop SPE ist mit
dem zweiten Eingang der dritten Addierschaltung A3 und
außerdem mit dem Rücksetzeingang RA des zweiten Flipflops
SPA verbunden, das den Ausschaltzustand des Lasersenders
speichert. Der Takteingang ClA dieses Flipflops ist ebenfalls mit einem Tastschalter oder ähnlichem bzw. einer
Ausschaltelektronik zu verbinden, über den der Sender ausgeschaltet werden kann. Der Ausgang QA des zweiten D-
Flipflop SPA ist mit den zweiten Eingängen der ersten und
der zweiten Addierschaltung A1 und A2 verbunden.

Der Laserdiodensender besteht aus drei Funktionseinheiten:
der Arbeitspunktregelung, die den Vorstrom der Laserdiode regelt; der Modulationsstromregelung und der Ablaufsteuerung, die mit Hilfe der beiden Betriebszustandsspeicher SPE und SPA erfolgt. Zur Arbeitspunktregelung
wird das von der Monitordiode detektierte Pilotsignal
im Mischer M mit einem Referenzsignal verglichen und das
Differenzsignal nach Integration im Integrator INTV zur
Erzeugung einer Regelspannung für den Vorstrom $I_V$ verwendet. Zur Modulationsstromregelung wird eine dem mittleren
Sendelicht proportionale Spannung mit einer Referenzspannung $U_{M2R}$ verglichen, die aus den durch den ersten
und dem zweiten Widerstand R1, R2 gebildeten Spannungsteiler heruntergeteilten Ausgangssignal des Detektors DET

**0141191**

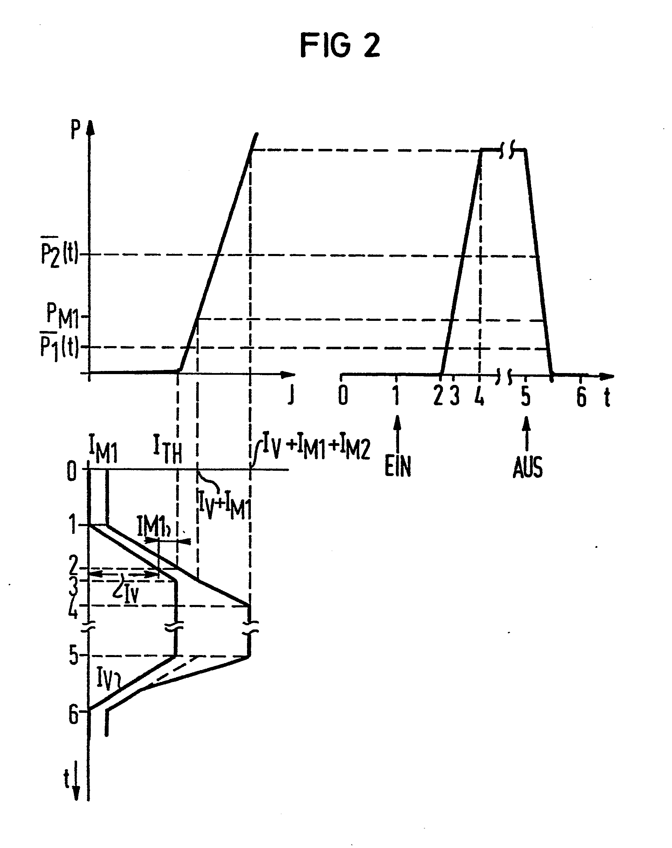

erzeugt wird. Die beiden Betriebszustandsspeicher steuern zusammen mit dem Schwellenwertdetektor DET, der das Erreichen des vorgewählten, reduzierten Lichtmittelwertes anzeigt, das Einschalten des Lasersenders, die Freigabe der beiden Regelkreise und das Abschalten des Lasersenders. Das Einschalten und das Abschalten des Laserdiodensenders nach der Fig. 1 wird im folgenden anhand der Diagramme nach der Fig. 2 näher erläutert.

In der Fig. 2a ist links oben die Kennlinie einer Laserdiode dargestellt, wobei mit $P_{M1}$ die Impulsspitzen-Lichtleistung bezeichnet ist, die die Laserdiode abgibt, wenn ihr neben dem Vorstrom $I_V$ und dem Pilotsignal der in der Einschaltphase maximal zulässige Modulationsstrom $I_{M1}$ zugeführt wird. Unter dieser Kennlinie sind im zeitlichen Ablauf die einzelnen die Laserdiode durchfliessenden Ströme ($I_V$: Strichpunktiert, $I_V + I_{M1} + I_{h2}$: durchge- zogene Kurve) dargestellt, während rechts von der Laserdiodenkennlinie das von der Laserdiode abgegebene Licht ebenfalls im zeitlichen Ablauf mit den Zeitpunkten (= 0 bis t = 6) dargestellt ist.

Zum Zeitpunkt t = 0 liegt der Ruhezustand bei ausgeschalteter aber betriebsbereiter Laserdiode vor, am Ausgang QE des ersten D-Flipflop SPE liegt dabei der logische Nullzustand an, während am Ausgang QA des zweiten D-Flipflop der logische Einszustand anliegt. Zu dieser Zeit ist, wie noch gezeigt wird, der von der Monitordiode detektierte Lichtmittelwert sehr klein und der eingestellte reduzierte Schwellwert $U_{M1R}$ ist nicht erreicht. Der Ausgang von DET ist damit auf negativem Spannungspegel und der Logikpegel ist auf Null. Damit ist der positive Eingang von INTM noch negativer.

Die Addierschaltung A1 erhält die geringe Ausgangsspannung vom Verstärker PV und das positive Signal QA vom Ausgang der zweiten D-Flipflops SPA. Der Ausgang der Addierschaltung A1 ist somit log "1" (High). Damit ist der Ausgang des Integrators INTM negativ (LOW) und der zweite Modulationsteilstrom $I_{M2}$ ausgeschaltet. Es fließt nur der konstante Modulationsteilstrom $I_{M1}$. Dieser ist notwendig, damit in der Einschaltphase, in der der geregelte und die Laserdiode gefährdende zweite Modulationsteilstrom $I_{M2}$ ausgeschaltet ist, der dem Modulationsstrom $I_M$ aufmodulierte Pilot (PS) im Laserlicht vorhanden ist und den Arbeitspunkt mithilfe des Vorstrom $I_V$ einregeln kann.

Der ausgewertete Pilot regelt über den Mischer M und den Integrator INTV den Vorstrom $I_V$. Dieses Verfahren ist notwendig bei modernsten Laserdioden mit der Lichtwellenlänge von $\lambda = 1,3 \mu m$ und sehr geringen Schwellenströmen von ca. 10 mA. Bei Lasern mit hohen Schwellenströmen muß die Einschalthilfe mit dem Zusatzstrom $I_Z$ additiv hinzugefügt sein.

Mit dem Ausgang QA sind über A2 die invertierenden Eingänge des Vorstromintegrators INTV und (über A1) des Modulationsstromintegrators INTM verbunden, so daß die von diesen abgegebenen Regelspannungen dem ungeregeltem Zustand der Laserdiode entsprechen und nur der reduzierte Modulationsstrom $I_{M1}$ mit dem aufmodulierten Modulationssignal PS durch die Laserdiode fließt ($I_V = 0$).

Zum Zeitpunkt t = 1 wird die Laserdiode über eine positive Schaltflanke am Eingang C1E des ersten D-Flipflop SPE eingeschaltet. Der logische Einspegel am Ausgang QE bewirkt über den Rücksetzeingang RA des zweiten D-Flipflops, daß dieses zurückgesetzt wird und an seinem Ausgang QA der logische Nullpegel erscheint. Der logische Einspegel am Ausgang QE bewirkt außerdem, daß über die dritte Addierschaltung A3 mithilfe des Integrators INTV der Vorstromregler eingeschaltet wird und der Ausgangsstrom $I_V$ der Quelle $Q_V$ zügig ansteigt.

Der Integrator INTM bleibt ausgeschaltet. Am invertierenden Eingang des Integrators INTM liegt der LOW-Pegel vom Ausgang QA des D-Flipflops SPA und bei leicht ansteigender Ausgangsspannung vom Verstärker PV, der positive Eingang ist wegen des Spannungsteilers aus den Widerständen R1 und
R2 jedoch noch negativer, somit bleibt der zweite Modulationsteilstrom $I_{M2}$ auf dem Wert Null.

Zum Zeitpunkt t = 2 hat die Summe aus Vorstrom $I_V$ und
Modulationsteilstrom $I_{M1}$ den Schwellenwert ($I_{TH}$) der
Laserdiode erreicht, die Laserdiode beginnt mit der
Lichtaussendung. Bei Lasern mit sehr kleinen Schwellenströmen kann t = 2 gegen t = 1 gehen.

Zum Zeitpunkt t = 3 hat der von der Laserdiode abgegebene
Lichtmittelwert . den über die Referenzspannung $U_{M1R}$ am
Schwellenwertdetektor DET eingestellten reduzierten Lichtmittelwert $\overline{P_1(t)}$ erreicht. Beim Überschreiten dieses
Wertes gibt der Schwellenwertdetektor DET ein positives
Ausgangssignal ab (High), das zum Rücksetzen des ersten
D-Flipflops SPE führt. Mit dem High-Zustand am Ausgang
von DET wird der Modulationsstromintegrator INTM freigegeben, so daß nun beide Regelkreise wirksam sind und der
von der Quelle $Q_{M2}$ abgegebene zweite und geregelte Modulationsteilstrom $I_{M2}$ ansteigt.

Die Freigabe des Integrators INTM erfolgt durch den Anstieg der Spannung $U_{M2R}$. Ihr Spannungsteiler aus den
Widerständen R1 und R2 bestimmt dabei gemeinsam mit dem
Ausgangspegel des Detektors von DET (High) den Wert der
Spannung $U_{M2R}$. Diese ist nun die Referenzspannung für den
Sollwert des Lichtmittelwertes $\overline{P_2(t)}$ für die voll in
Betrieb befindliche Laserdiode.

Zum Zeitpunkt t = 4 ist der stationäre Betriebszustand
erreicht, beide Regelkreise sind wirksam, ohne daß bei
der Einstellung die zulässige Lichtspitzenleistung
der Laserdiode überschritten wurde.

Zum Zeitpunkt t = 5 erfolgt das Ausschalten des Laserdiodensenders.

**0141191**

Das Ausschalten erfolgt durch eine positive Schaltflanke am Eingang C1A des zweiten D-Flipflops SPA, wodurch der Ausgang $Q_A$ den logischen Einspegel annimmt. Über die erste und die zweite Addierschaltung A1 und As wird der logische Einspegel an die invertierenden Eingänge des Modulationsstroms- und des Vorstromintegrators gegeben und dadurch diese ausgeschaltet.

Zum Zeitpunt t = 6 ist der Ausschaltzustand wieder erreicht.

Durch die Möglichkeit des Auftrennens der Regelkreise während der Einschaltphase ist die Laserdiode vor Überlastung geschützt. Die Höhe des reduzierten Lichtmittelwertes $\overline{P_1}(t)$ ist frei wählbar. Der prinzipielle Verlauf der Steuer- und Regelvorgänge bleibt erhalten, auch wenn die Laserdioden eine von der Fig. 2 abweichende Kennlinie, beispielsweise mit einem stark abgerundetem Kennlinienknick oder sehr geringem Schwellwertstrom aufweisen. Die Schaltschwelle wird zweckmäßigerweise in den linearen Teil der Kennlinie leicht oberhalb des Kennlinienknicks verlegt.

6 Patentansprüche

2 Figuren

## Patentansprüche

1. Verfahren zur Regelung des Vorstroms und des Modulationsstroms von Laserdioden durch Auswertung des Mittelwertes des erzeugten Lichtes und eines zusätzlich übertragenen, gegenüber den Übertragungssignalen vergleichsweise niederfrequenten Pilotsignals geringer Amplitude, bei dem ein Teil des von der Laserdiode abgestrahlten Lichtes am Ort in eine elektrische Spannung umgeformt wird und aus der Höhe dieser Spannung die mittlere Lichtleistung der Laserdiode ermittelt wird, daß die mittlere Lichtleistung der Laserdiode zur Steuerung des Modulationsstroms und die Pilotsignalamplitude im abgestrahlten Licht bzw. der daraus erzeugten Spannung zur Steuerung des Vorstroms verwendet wird und während der Einschaltphase die Modulationsstromregelung abgeschaltet ist, d a d u r c h g e k e n n z e i c h n e t, daß in der Einschaltphase zunächst der Modulationsstrom und damit auch der von der Laserdiode abgebbare Lichtspitzenwert auf einen für derartige Laserdioden ungefährlichen Wert begrenzt sind, daß nach Überschreiten des Schwellenwertes der Laserdiode durch die Summe aus Vorstrom und wirksamen Modulationsstrom bei Gleichheit des von der Laserdiode abgegebenen Lichtmittelwertes mit dem vorgegebenen reduzierten Lichtmittelwert die Modulationsstrombegrenzung abgeschaltet wird.

2. Verfahren nach Patentanspruch 1, d a d u r c h g e k e n n z e i c h n e t, daß bei Abschalten der Laserdiode als erstes die Regelkreise für Vorstrom und Modulationsstrom abgeschaltet werden.

3. Verfahren nach Patentanspruch 1, d a d u r c h g e k e n n z e i c h n e t, daß der Modulationsstrom ($I_M$) aus zwei Teilströmen ($I_{M1}$, $I_{M2}$) gebildet wird und einer der Teilströme ($I_{M1}$) dem in der Einschaltphase zulässigen Modulationsstrom entspricht.

4. Anordnung zur Durchführung der Verfahren nach Ansprüchen 1, 2 oder 3,

d a d u r c h   g e k e n n z e i c h n e t ,

daß als optischer Sender eine Laserdiode (LD) vorgesehen ist, an die optisch eine Monitordiode (MD) angekoppelt ist, deren einer Anschluß mit Bezugspotential und deren anderer Anschluß mit einem Verstärker (PV) verbunden ist, daß mit dem Ausgang des Verstärkers (PV) der nichtinvertierende Eingang eines als Schwellenwertdetektors (DET) wirksamen Differenzverstärkers verbunden ist, daß außerdem mit dem Ausgang des Verstärkers (PV) ein Eingang eines Mischers (M) und ein Eingang einer ersten Addierschaltung (A1) verbunden ist, daß mit dem invertierenden Eingang des Differenzverstärkers (DET) eine Quelle für eine Referenzspannung $(U_{M1R})$ verbunden ist, daß der Ausgang des Differenzverstärkers (DET) mit dem Rücksetzeingang (RE) eines ersten, als Speicher für den Einschaltzustand dienenden D-Flipflops (SPE) und außerdem mit dem nichtinvertierenden Eingang eines Integrators für den Modulationsstrom (INTM) verbunden ist, daß der Takteingang (ClE) des ersten D-Flipflops (SPE) mit einem Einschalter verbunden ist und an den Ausgang (QE) dieses Flipflops der Rücksetzeingang (RA) eines als Ausschaltspeicher wirksamen zweiten D-Flipflops (SPA) sowie ein Eingang einer dritten Addierschaltung (A3) verbunden ist, daß der Eingang (ClA) des zweiten D-Flipflops (SPA) mit einem Ausschalter verbunden ist und der Ausgang (QA) dieses Flipflops mit einem weiteren Anschluß der ersten Addierschaltung (A2) sowie mit einem zweiten Eingang der zweiten Addierschaltung (A2) verbunden sind, daß ein Ausgang des Mischers (M) mit einem weiteren Eingang der zweiten Addierschaltung (A2) und deren Ausgang mit dem invertierenden Eingang eines Integrators (INTV) für den Vorstrom verbunden ist, daß ein zweiter Ausgang des Mischers (M) mit einem weiteren Eingang der dritten Addierschaltung (A3) verbunden ist, an deren Ausgang der nichtinvertierende Eingang des Integrators (INTV) für den Vorstrom angeschlossen ist, daß der Ausgang dieses Integrators mit dem Regeleingang einer regelbaren Quelle ($Q_V$) für den Vorstrom verbunden ist, deren Ausgang mit dem ersten Anschluß einer Pilotsignalquelle (PS) sowie über die Laserdiode (LD) mit Bezugspotential verbunden ist, daß der erste Anschluß der Pilotsignalquelle (PS) mit einem zweiten Eingang des Mischers (M) verbunden ist, daß der Ausgang des Integrators (INTM) für den Modulationsstrom mit einer regelbaren Quelle ($Q_{M2}$) für einen zweiten Modulationsteilstrom ($I_{M2}$) verbunden ist, daß eine Quelle ($Q_{M1}$) für den ersten Modulationsteilstrom vorgesehen ist und die Ausgänge der Quellen beider Modulationsteilströme miteinander, mit dem zweiten, zum ersten Anschluß gegenphasigen Anschluß der Pilotsignalquelle (PS) und über einen gesteuerten Schalter (SM) mit der Laserdiode verbunden sind und daß mit dem Steuereingang (ÜS) des gesteuerten Schalters (SM) eine Quelle für ein Übertragungssignal verbunden ist.

5. Anordnung nach Patentanspruch 4,
d a d u r c h   g e k e n n z e i c h n e t ,
daß der Mischer (M) ein mit dem Eingang verbundenes Filter enthält, das aus dem Ausgangssignal des Verstärkers (PV) die sendeseitig zugesetzte Pilotsignalkomponente aussiebt.

6. Anordnung nach Patentanspruch 4,
d a d u r c h   g e k e n n z e i c h n e t ,
daß die Integratoren (INTM und INTV) für den Modulationsstrom und den Vorstrom je einen Differenzverstärker enthalten, dessem Ausgang eine Speicherkapazität parallelgeschaltet ist.

FIG 1

## FIG 2